# EUROPEAN PATENT SPECIFICATION

(11) **EP 2 624 452 B1**
(45) Date of publication and mention of the grant of the patent: **02.01.2019**
(21) Application number: 13000504.4
(22) Date of filing: 01.02.2013
(51) Int. Cl.: H03K 17/96, H01R 12/71, H05K 7/12, H01R 12/70

(54) **A capacitive sensor for printed circuit boards and set made up of capacitive sensor and a printed circuit board**
Kapazitativer Sensor für Leiterplatten und Satz aus einem kapazitativen Sensor und einer Leiterplatte
Capteur capacitif pour cartes de circuit imprimé et ensemble constitué d'un capteur capacitif et carte de circuit imprimé

(30) Priority: 03.02.2012 PL 39799612
(43) Date of publication of application: 07.08.2013
(73) Proprietor: Diehl AKO Stiftung & Co. KG, 88239 Wangen (DE)
(72) Inventor: Popiel, Adam, 67-320 Malomice (PL)
(74) Representative: Diehl Patentabteilung

(56) References cited:
- WO-A1-2010/038034
- DE-A1-102009 021 033
- US-A- 6 045 653

## Description

The subject of the invention is a capacitive sensor arrangement comprising a sensor element mounted on a printed circuit board. The invention is intended for use in touch keypads or related capacitive sensors used in connection with a printed circuit board in various electrically operated devices.

Capacitive touch sensors used with printed circuit boards are employed to detect the presence of a certain element across an electrically insulating material, such as glass or ceramic. The capacitive sensor element is electrically connected to an electronic circuit, such as a printed circuit board, which detects a change in capacitance when the element makes contact with or approaches the sensor and transforms these changes into an active or inactive state of the device.

From patent specification EP0780865 (as well as US 5892652) there is known a capacitive sensor element designed for mounting on a printed circuit board. The sensor element contains a flexible element, which is formed as a single piece and has the shape of a flexible oblong sheet of material conducting an electric current, bent in the shape of the letter Z. The flexible element contains an upper platform and a support, which has a base essentially parallel with the upper platform and a middle part joining them. In the base there are formed pins, also being of one piece with it, for fastening the flexible element to the printed circuit board. The support is connected to the upper platform for fastening at one edge of the upper platform for fastening. As a result of this, the versatility of positioning of the upper platform relative to the base of the support and the printed circuit board is limited. This sensor element is fastened to the printed circuit board by placing the pins into openings and soldering them to form an electrical connection. This is tedious and time-consuming.

DE 10 2009 021 033 A1 discloses a capacitive sensor arrangement comprising a printed circuit board and a sensor element mounted on the printed circuit board. The sensor element contains a platform for sensing the presence of an element across an insulating sheet, which platform is articulated to two elastically deformable supports. Each of the two supports is terminated at the bottom by a pin which is placed in a bore in the printed circuit board to position the sensor element on the printed circuit board.

The goal of the invention is to develop a capacitive sensor arrangement which ensures a versatile positioning of the upper platform of the sensor element with respect to the printed circuit board to which it is secured.

Another goal of the invention is to develop a capacitive sensor arrangement which ensures easy adaptation of the sensor element to the position of the insulation sheet, making contact with it from above, of the device in which it is installed.

The next goal of the invention is to provide a capacitive sensor arrangement that has a design ensuring an easy and secure fastening of the sensor element to the printed circuit board.

According to the invention, the sensor element of the capacitive sensor arrangement contains a platform for sensing the presence of an element across an insulating sheet, which platform is articulated to two elastically deformable supports, adapted for fastening to a printed circuit board and holding the platform above this printed circuit board, wherein the supports are joined to the platform by an articulation with an axis of rotation on either side of which is located part of the upper platform to secure the positioning of the platform on the supports in any given inclined plane relative to the surface of the printed circuit board or flexure of the platform. Further, the printed circuit board contains at least two parallel slot openings having external edges. Furthermore, at least one of the two supports of the sensor element is terminated at the bottom by a clip which is placed in a slot opening of the printed circuit board for fastening the sensor element to the printed circuit board. According to the invention, the clip has the form of a curved sheet forming a horizontal bend extending from the bottom of the support in a direction to the middle of the sensor element, a vertical bend extending from the horizontal bend downward, and a terminal bend extending from the vertical bend in a direction to the outside of the sensor; and a distance between the external edges of the slot openings of the printed circuit board is less than the distance between the closest parts of the two supports of the sensor element in the plane of fastening the supports to the printed circuit board so that a pressure of the supports on the external edges of the slot openings is constantly maintained.

In an advantageous configuration, the supports of the sensor element contain two arms, each having an upper end and a lower end, while each arm is articulated by the upper end to the side of the platform and is bent downward in the direction to the outside and along the platform, while at the lower end both arms are joined together by means of a terminal part.

In another advantageous configuration, the supports of the sensor element contain one arm having an upper end and a lower end, while the arm is articulated by the upper end to the platform in its middle region and is curved downward in the direction to the outside and along the platform, while at the lower end it is terminated by a terminal part.

The terminal part of one or both of the two supports can be terminated at the bottom by a clip for fastening the sensor to the printed circuit board.

Further, the terminal part of one of the two supports can have at least one pin situated on the lower edge for placement in a slot opening of the printed circuit board.

Advantageously, the platform and the supports of the sensor element are made as a single piece by cutting and bending from a metal strip.

The platform of the sensor element can have a shape chosen from among rectangular, oval, circular.

Advantageously, the two supports can project symmetrically downward in the direction of the outside and along the platform for self-locking attachment of the supports in slot openings of the printed circuit board.

The capacitive sensor arrangement of the invention assures the possibility of a diverse positioning of the upper platform of the sensor element and adapting of its position to the shape and position of the insulating sheet beneath which the sensor element is mounted. The capacitive sensor arrangement of the invention also provides a firm, self-locking attachment of the sensor element to the printed circuit board.

In the present specification and claims, the terms "top", "bottom" and the like refer to the position of the capacitive sensor element in which its upper platform is situated in a horizontal or similar position, while the supports are situated for connection to the horizontally placed printed circuit board. However, it should be understood that any given arrangements in the area of the set of capacitive sensor and printed circuit board are possible. The term "lengthwise direction of the sensor" refers to the direction designated by the intersection of the sensor element with the plane of symmetry of the supports and the upper platform. The "transverse direction" is the direction perpendicular to the lengthwise direction.

The subject of the invention in example embodiments is indicated in the drawing, where:
Figure 1 shows a first example embodiment of the capacitive sensor element in perspective view from above;
Figure 2 shows the capacitive sensor element from Fig.1 in elevation from above;
Figure 3 shows the capacitive sensor element from Fig.1 in elevation from the support side;
Figure 4 shows the capacitive sensor element from Fig. 1 fastened in a printed circuit board in side elevation, with the printed circuit board shown in cross section;
Figure 5 shows a modification of the capacitive sensor element of Fig. 1, fastened in a printed circuit board in side elevation, with the printed circuit board shown in cross section;
Figure 6 shows another modification of the capacitive sensor element of Fig. 1, fastened in a printed circuit board in side elevation, with the printed circuit board shown in cross section, as a comparative example;

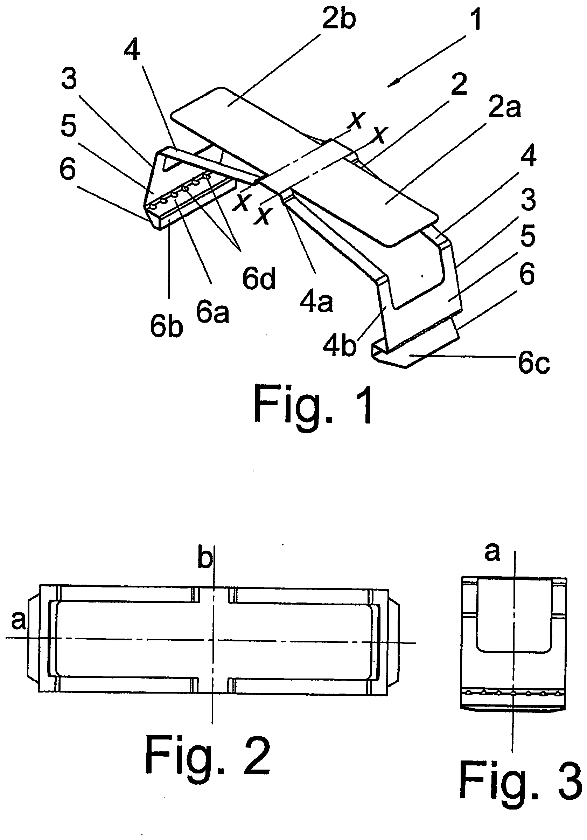

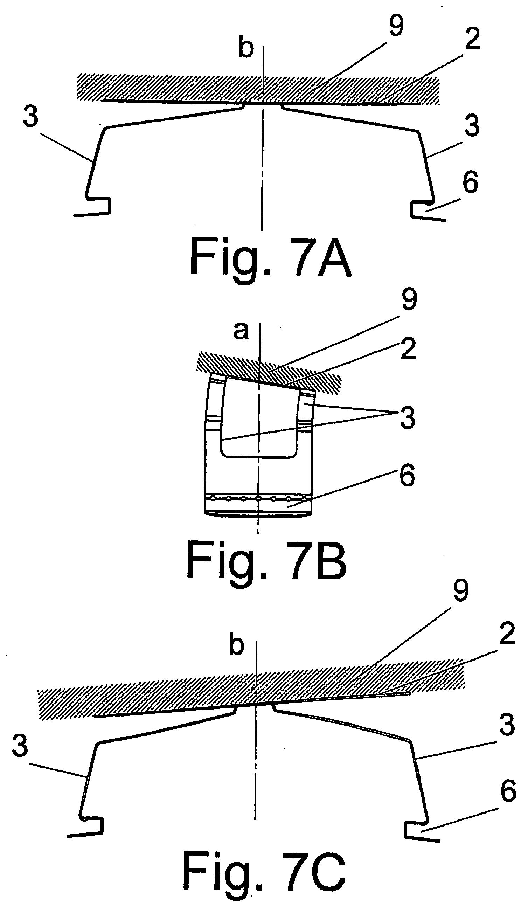

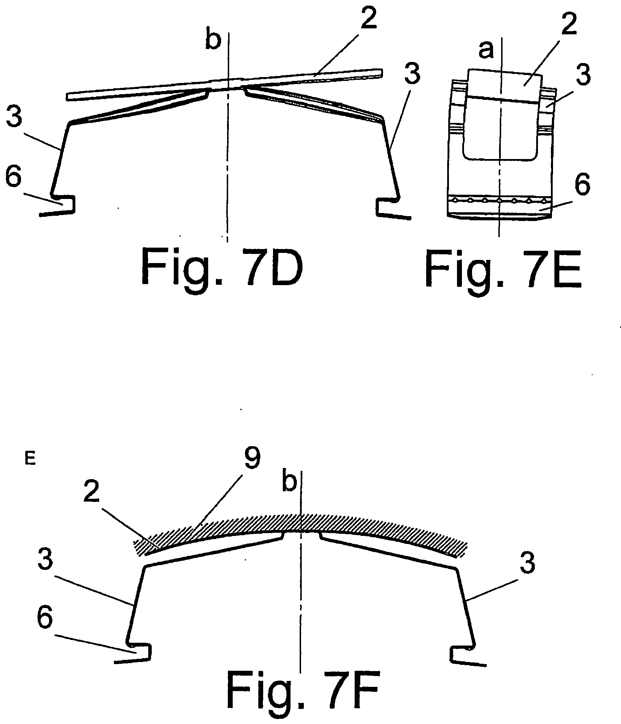

Figure 7A-7F show the capacitive sensor element of Fig. 1 in various possible positions of the upper platform relative to the plane designated by the clips of the sensor element and then, after its mounting, relative to the surface of the printed circuit board; where Fig. 7A shows the capacitive sensor element with platform located in a plane parallel to the plane designated by the clips; Fig. 7B shows the capacitive sensor element with the platform placed at an inclination relative to the lengthwise plane of the sensor and the plane designated by the clips; Fig. 7C shows the capacitive sensor element with the platform placed at an inclination relative to the transverse plane of the sensor and the plane designated by the clips; Fig. 7D, 7E show the capacitive sensor element with the platform placed at an inclination relative to both the lengthwise and the transverse plane of the sensor and the plane designated by the clips; Fig. 7F shows the capacitive sensor element with platform bent relative to the lengthwise plane of the sensor;
Figure 8 shows another modification of the capacitive sensor element of Fig. 1 in perspective view from above, as a comparative example;
Figure 9 shows the capacitive sensor element of Fig. 8, fastened to the printed circuit board, in side elevation;
Figure 10 shows a second example embodiment of the capacitive sensor element in perspective view from above;
Figure 11 shows a modification of the capacitive sensor of Fig. 10 in perspective view from above, as a comparative example.

The sensor element 1 of the capacitive sensor arrangement is presented in example embodiments in drawings, where corresponding parts of the sensor element are designated by identical reference numbers.

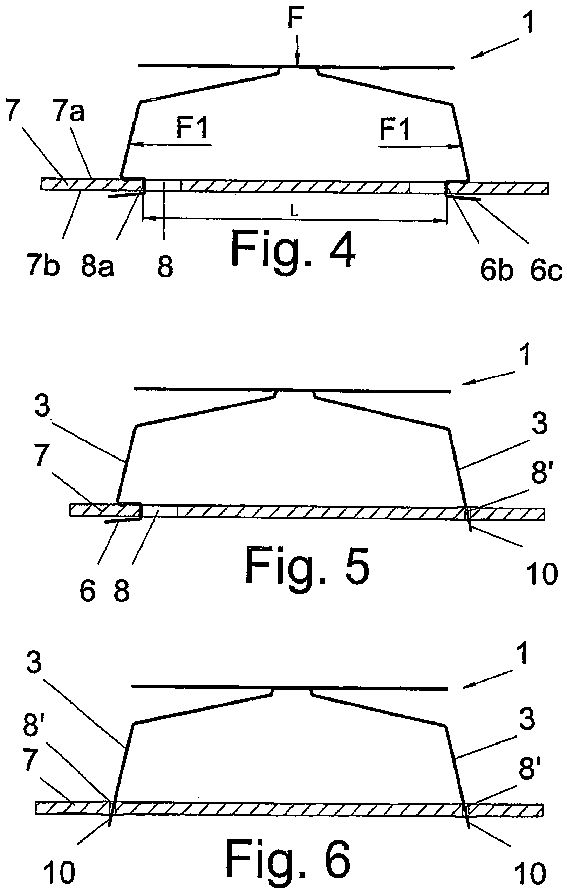

In the first example embodiment and its modifications of the invention shown in Figs. 1-5 and 7, the capacitive sensor element 1 has a platform 2 for sensing the presence of an element across an insulating sheet. The platform 2 is articulated to two elastically deformable supports 3, which are adapted for fastening to a printed circuit board 7 (shown in Fig. 4) in order to hold the platform 2 above this printed circuit board 7.

The supports 3 are fastened to the platform 2 so that the articulation formed has an axis of rotation X-X, on either side of which is situated part of the platform, respectively, the first part 2a and the second part 2b. Thanks to the connection of the platform 2 to the supports 3 forming an articulation with axis of rotation X-X, on either side of which is situated a part 2a, 2b of the platform 2, it is possible to place the platform 2 on the supports 3 in any given inclined plane relative to the plane of the surface of the printed circuit board 7 to which the sensor element 1 is mounted and/or it is possible to flex the platform 2. In this example embodiment, the platform 2 has a rectangular shape.

However, the shape of the platform 2 can be different, in particular, oval or circular. The parts 2a, 2b of the platform do not need to be identical and/or symmetrical.

In the example embodiment of Figs. 1-4, these two supports 3, in the free state, project downward symmetrically from the platform 2 in the direction to the outside and along the platform 2. Each support 3 contains two arms 4, each of which is articulated by its upper end to the side of the platform 2 and is curved downward in the direction to the outside and along the platform 2. At their lower ends, both arms 4 are joined together by means of a terminal part 5 having the shape of a rectangular sheet. The terminal part 5 of the support 3 is connected at the bottom to a clip 6 for fastening the capacitive sensor element 1 in slot openings 8 formed in the printed circuit board 7 (Fig. 4).

The clip 6 has the form of a bent sheet forming a horizontal bend 6a extending from the terminal part 5 toward the middle of the platform 2 of the capacitive sensor element 1, a vertical bend 6b extending from the horizontal bend 6a to the bottom, and a terminal bend 6c extending from the vertical bend 6b in the direction of the outside of the platform 2. To facilitate the placement of the clip 6 in the slot opening 8 of the printed circuit board 7, the terminal bend 6c is beveled on its sides. The horizontal bend 6a and/or the terminal bend 6c of the clip 6 can be outfitted with elements 6d placed along the clip 6, such as embossings, to improve the electrical contact of the clip 6 with the printed circuit of the board in which the sensor is to be mounted.

As shown in Fig. 4, in order to fasten the capacitive sensor element 1 in the printed circuit board 7 the clips 6 of its two supports 3 are placed in parallel slot openings 8 formed in the printed circuit board 7, at the same time holding the supports 3 in a state of slight approach to each other. Thanks to this, the clips 6 are seated in the slot openings 8 such that the lower surfaces of the horizontal bend 6a of the clip 6 comes into contact with the upper surface 7a of the printed circuit board 7, and the upper surface of the terminal bend 6c of the clip 6 makes contact with the lower surface 7b of the printed circuit board 7. After releasing the pressure of the supports 3 against each other, the vertical bend 6b of the clip 6 of each support 3 rests against the external lateral surface 8a of the slot opening 8.

The distance L of the external edges 8a of the two parallel slot openings 8 of the printed circuit board 7 is less than the distance between the closest parts of the opposite supports 3 in the plane of fastening of the supports 3 to the printed circuit board 7. In this case, this is the distance between the vertical bends of the opposite clips 6 of the supports 3, so that after fastening of the capacitive sensor element 1 in the printed circuit board 7 the pressure of the clips 6 on the external edges 8a of the slot openings 8 is constantly maintained.

As shown in Fig. 4, such a fastening of the capacitive sensor element 1 in the slot openings 8 of the printed circuit board 7 ensures that, due to the tendency of the supports 3 and clips 6 to expand and move away from each other due to eliminating the initial pressure of the supports 3 against each other and also due to possible subsequent exerting of pressure F from above on the upper platform 2, there occurs only a locking of the clips 6 in the slot openings 8 by the force F1 in the lengthwise direction of the sensor. Thanks to this, no additional fixing of the clips 6 to the printed circuit board 7 is necessary, such as by soldering.

At the same time, the supports 3 are firmly supported by means of the upper bend 6a of each clip 6 on the printed circuit board 7, which ensures the possibility of adapting the position of the platform 2 relative to the surface of the printed circuit board 7 according to requirements, for example, by adapting to the available space in the device containing the set of capacitive sensor and printed circuit board or to the shape and/or position of the insulating sheet beneath which the capacitive sensor element 1 is placed.

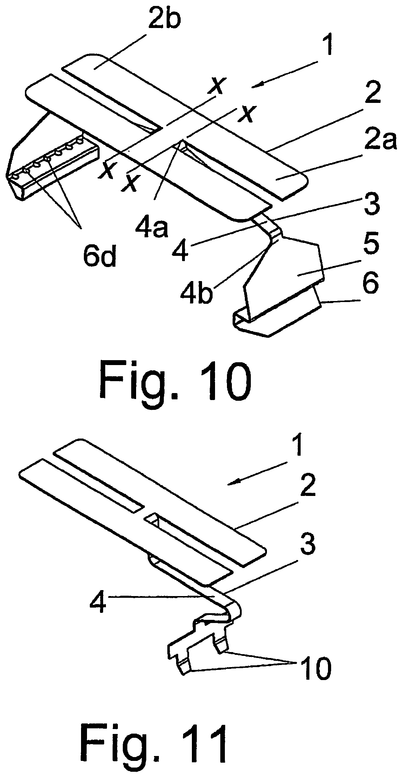

Figure 5 and 6 show modifications of the sensor element of Fig. 1-4. In the first modification of the invention (Fig. 5), one of the supports 3 of the sensor element 1, instead of having a clip 6, has a terminal part with at least one pin 10 projecting downward from its lower edge (as shown in Fig. 10 and 14, discussed below), which serves for placement in a slot opening 8' in the printed circuit board 7 that is shorter and narrower than the slot openings 8 of the first example embodiment, and fashioned accordingly. In the second modification being a comparative example (Fig. 6), in both of the supports 3 the clips 6 are replaced by pins 10, which are placed in slot openings 8' in the printed circuit board 7 that are fashioned in sets parallel to each other.

Also in these two modifications, after mounting the capacitive sensor element 1 in the printed circuit board 7, one can assure a constantly maintained pressure of the supports 3 against the external edges of the slot openings 8', so that no additional fixing of the supports 3 to the printed circuit board 7 is required. For this purpose, the distance L of the external edges of the parallel slot openings 8' of the printed circuit board 7 should be less than the distance between the closest parts of opposite supports 3 in the plane of fastening of the supports 3 to the printed circuit board 7. In this case, this is the distance between the pins 10 of opposite supports 3.

Possible variants of placement of the platform 2 of the capacitive sensor element 1 of Figs. 1-3 relative to the plane designated by the clips of the supports are shown in Figs. 7A-7F. The plane designated by the clips 6 of the supports 3 or the lower edge of the terminal part 5, from which the pins 10 stand out, corresponds to the plane of the printed circuit board to which the capacitive sensor element 1 is going to be mounted. For clarity, the horizontally situated printed circuit board to which the sensor element can be secured has been omitted.

Figure 7A shows the position of the capacitive sensor element 1 in which the platform 2 is horizontally situated, while the supports 3 are placed symmetrically with respect to the lengthwise "a" and transverse "b" planes of symmetry of the capacitive sensor element 1 (as shown in Fig. 4 and 5). In such a position, the platform 2 can be lowered, i.e., brought nearer to the plane designated by the clips 6 of the supports 3, for example, by adjusting the capacitive sensor element 1 to less distance between the insulating sheet 9 and the printed circuit board 7, while maintaining their parallel position relative to each other.

Figure 7B shows the position of the capacitive sensor element 1 in which the platform 2 is inclined relative to the plane designated by the clips 6 of the supports 3, by tilting it relative to the lengthwise plane of symmetry "a" of the sensor. In such a position, the arms of the supports 3 situated on one side of the lengthwise plane of symmetry "a" of the sensor are more bent than the arms of the supports 3 placed on the opposite side of the lengthwise plane of symmetry "a" of the sensor.

Figure 7C shows the position of the capacitive sensor element 1 in which the platform 2 is inclined relative to the plane designated by the clips 6 of the supports, by tilting it relative to the transverse plane of symmetry "b" of the sensor. In such a position, the arms of the supports 3 situated on one side of the transverse plane of symmetry "b" of the sensor are more bent than the arms of the supports 3 placed on the opposite side of the transverse plane of symmetry "b" of the sensor.

Figures 7D and 7E show the position of the capacitive sensor element 1 in which the platform 2 is inclined relative to the plane designated by the clips of the supports, both by tilting it relative to the lengthwise plane of symmetry "a" and the transverse plane of symmetry "b" of the sensor. In such a position, each of the arms of the supports is bent differently with respect to the plane designated by the clips of the supports.

Figure 7F shows the position of the capacitive sensor element 1 similar to that shown in Fig. 7A. The supports 3 are situated symmetrically and raised to identical heights, while the platform 2 is curved according to the shape of the insulating sheet 9, which makes contact with the platform 2 of the sensor from above. Such a position of the upper platform 2 is possible thanks to the fastening of the supports 3 to the platform 2 such that the resulting articulation has an axis of rotation X-X, on either side of which one of the parts 2a, 2b of the platform 2 is situated. Although Fig. 7F shows the capacitive sensor element 1 with platform 2 curved convexly upward, a convex downward curving of the platform 2 is also possible.

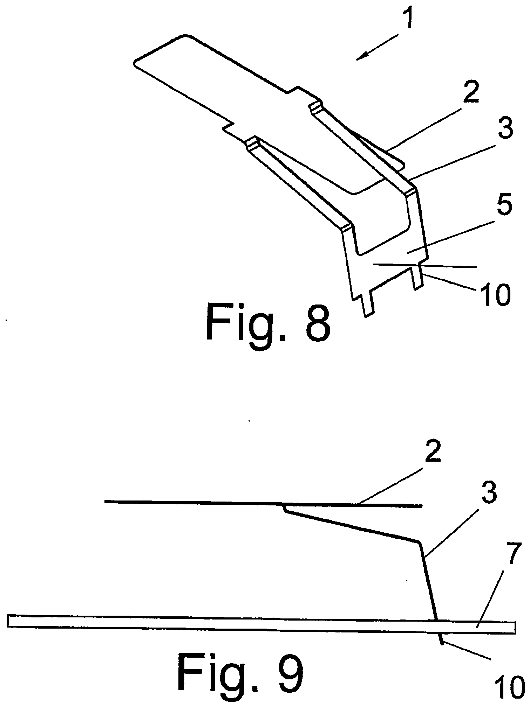

Figures 8 and 9 show, as a comparative example, another modification of the first example embodiment of the capacitive sensor element 1, in which the capacitive sensor element 1 contains only one support 3 with the design as described in regard to Figs. 1-3 in its modified version of Figs. 5, 6. This support 3 contains pins 10 projecting from the lower edge of the terminal part 5 of the support 3. The pins 10 serve for placement in openings arranged accordingly in the printed circuit board 7. Due to the fact that in this case no locking effect of the pins 10 occurs in the openings of the board 7, the pins 10 are additionally fastened to the printed circuit board 7, for example, by soldering. The difference is the reversed configuration of the clip 6'. The clip 6' has the shape of a curved sheet forming an upper bend 6'a extending from the terminal part 5 in the direction to the outside of the capacitive sensor element 1, a vertical bend 6b extending from the upper bend 6'a downward and a lower bend 6'c extending from the vertical bend 6'b toward the middle of the capacitive sensor element 1.

Figure 10 shows a second example embodiment of the capacitive sensor element 1. As compared to the first example embodiment of Figs. 1-4, the capacitive sensor element 1 has a differently configured platform 2 and supports 3. Each support 3 contains one arm 4, which has an upper end articulated to the platform 2 in its middle region and is curved downward in the direction of the outside and along the platform 2. At its lower end, the arm 4 is terminated by a terminal part 5. The terminal part 5 is configured as in the first example embodiment and is also connected to the clip 6, configured the same as discussed in regard to the first example embodiment.

Also in this example embodiment, the supports 3 are fastened to the platform 2 such that the resulting articulation has an axis of rotation X-X, on either side of which is situated a part of the platform 2, respectively 2a and 2b, which ensures that the capacitive sensor element 1 can assume different positions with regard to the plane designated by the clips 6, as discussed in regard to Figs. 7A-7F. It should be pointed out that this design also facilitates the curving of the platform 2 of the sensor relative to the lengthwise plane "a" of the sensor (as shown in Fig. 7F in regard to the curving relative to the transverse plane "b"). It can also be provided that the platform 2 of the capacitive sensor element 1 according to this example embodiment can be curved convexly downward relative to the lengthwise plane "a" or the transverse plane "b" of the capacitive sensor element 1, or both these planes at the same time. Thanks to this, greater freedom is ensured in adapting the capacitive sensor element 1 to the conditions in which it will operate.

It should be noted that the sensor element according to the second example embodiment can be modified as described in regard to Fig. 5 showing the first example embodiment, that is, one support of the sensor can contain pins 10 instead of a clip 6.

Figure 11 shows, as a comparative example, a modification of the second example embodiment of the capacitive sensor element, which has one support 3 containing pins 10 instead of a clip 6, the pins being configured as described in regard to the example embodiment described and depicted in regard to Figs. 5, 6.

On the basis of the above presented example embodiments, modifications of the capacitive sensor element covered by the notion of the present invention will become obvious to the skilled persons in this field.

The most advantageous embodiment is when the capacitive sensor element 1 is made from a segment of metal strip appropriately cut out and curved into the shape of the three-dimensionally configured sensor element adapted to connect to a printed circuit board (as shown in Fig. 6). However, one can provide that the platform 2, support 3 and clip 6 of the support 3 are shaped separately from metal sheet and joined together by means of soldering, bonding, and similar techniques used for connection of metal sheets.

In the example embodiments depicted, the supports 3 are slanted from the plane of the platform 2 and then bent downward along the transverse line. But it can also be provided that the supports can be curved in an arc from the region of connection to the platform 2 to their lower end or curved in opposite directions and/or at different angles.

These and other modifications obvious to the skilled person in this field are covered by the enclosed patent claims which define the scope of protection of the invention.

### REFERENCE NUMBERS

- 1: capacitive touch sensor element
- 2: platform
- 3: support
- 4: arm
- 4a: upper end
- 4b: lower end
- 5, 5': terminal part
- 6,6': clip
- 6a: horizontal bend
- 6b: vertical bend
- 6c: terminal bend
- 7: printed circuit board
- 7a: upper surface
- 7b: lower surface
- 8, 8': slot opening
- 8a: external lateral surface of slot opening
- 9: insulating sheet
- 10: pin
- X-X: axis of rotation of articulation
- a: lengthwise plane of symmetry of sensor
- b: transverse plane of symmetry of sensor
- L: distance between external lateral surfaces
- F, F1: acting forces

## Claims

1. Capacitive sensor arrangement, comprising a printed circuit board (7) and a sensor element (1) mounted on the printed circuit board (7), wherein
the sensor element (1) contains a platform (2) for sensing the presence of an element across an insulating sheet (9), which platform (2) is articulated to two elastically deformable supports (3), adapted for fastening to the printed circuit board (7) and holding the platform (2) above the printed circuit board (7), wherein the supports (3) are joined to the platform (2) by an articulation with an axis of rotation (X-X) on either side of which is located part of the upper platform (2a, 2b) to assure the positioning of the platform (2) on the supports (3) in any given inclined plane relative to the surface of the printed circuit board (7) or flexure of the platform (2),
**characterized in that**
the printed circuit board (7) contains at least two parallel slot openings (8, 8') having external edges (8a);
at least one of the two supports (3) of the sensor element (1) is terminated at the bottom by a clip (6) which is placed in one of the at least two slot openings (8, 8') of the printed circuit board (7) for fastening the sensor element (1) to the printed circuit board (7), the clip (6) having the form of a curved sheet forming a horizontal bend (6a) extending from the bottom of the support (3) in a direction to the middle of the sensor element (1), a vertical bend (6b) extending from the horizontal bend (6a) downward, and a terminal bend (6c) extending from the vertical bend (6b) in a direction to the outside of the sensor (1); and
a distance (L) between the external edges (8a) of the slot openings (8, 8') of the printed circuit board (7) is less than the distance between the closest parts of the two supports (3) of the sensor element (1) in the plane of fastening the supports (3) to the printed circuit board (7), when the sensor element is unmounted, so that a pressure of the supports (3) on the external edges (8a) of the slot openings (8, 8') is constantly maintained, when the sensor element is mounted.

2. Capacitive sensor arrangement according to Claim 1, **characterized in that** the supports (3) of the sensor element (1) contain two arms (4), each having an upper end (4a) and a lower end (4b), while each arm (4) is articulated by the upper end (4a) to the side of the platform (2) and is bent downward in the direction to the outside and along the platform (2), while at the lower end (4b) both arms (4) are joined together by means of a terminal part (5).

3. Capacitive sensor arrangement according to Claim 1, **characterized in that** the supports (3) of the sensor element (1) contain one arm (4) having an upper end (4a) and a lower end (4b), while the arm (4) is articulated by the upper end (4a) to the platform (2) in its middle region and is curved downward in the direction to the outside and along the platform (2), while at the lower end it is terminated by a terminal part (5).

4. Capacitive sensor arrangement according to Claim 2 or 3, **characterized in that** the terminal part (5) of one or both of the two supports (3) of the sensor element (1) is terminated at the bottom by the clip (6).

5. Capacitive sensor arrangement according to Claim 2 or 3, **characterized in that** the terminal part (5) of one of the two supports (3) of the sensor element (1) has at least one pin (10) situated on the lower edge for placement in the slot opening (8) of the printed circuit board (7).

6. Capacitive sensor arrangement according to any one of the preceding claims, **characterized in that** the platform (2) and the supports (3) of the sensor element (1) are made as a single piece by cutting and bending from a metal strip.

7. Capacitive sensor arrangement according to any one of the preceding claims, **characterized in that** the platform (2) of the sensor element (1) has a shape chosen from among rectangular, oval, circular.

## Patentansprüche

1. Kapazitative Sensoranordnung, die eine Leiterplatte (7) und ein auf der Leiterplatte (7) angebrachtes Sensorelement (1) umfasst, wobei das Sensorelement (1) eine Plattform (2) zum Erfassen des Vorhandenseins eines Elementes über eine Isolierfolie (9) hinweg enthält, wobei die Plattform (2) an zwei elastisch verformbaren Trägern (3) angelenkt ist, die dazu ausgelegt sind, an der Leiterplatte (7) befestigt zu werden und die Plattform (2) über der Leiterplatte (7) zu halten, wobei die Träger (3) mit der Plattform (2) durch eine Gelenkverbindung mit einer Drehachse (X-X) verbunden sind, beiderseits derer sich ein Teil der oberen Plattform (2a, 2b) befindet, um die Positionierung der Plattform (2) auf den Trägern (3) in jeder beliebigen geneigten Ebene relativ zur Oberfläche der Leiterplatte (7) oder Durchbiegung der Plattform (2) zu gewährleisten,
**dadurch gekennzeichnet, dass**
die Leiterplatte (7) wenigstens zwei parallele Schlitzöffnungen (8, 8') mit Außenkanten (8a) enthält; wenigstens einer der beiden Träger (3) des Sensorelements (1) an der Basis mit einem Clip (6) abschließt, der zur Befestigung des Sensorelements (1) an der Leiterplatte (7) in eine der wenigstens zwei Schlitzöffnungen (8, 8') der Leiterplatte (7) platziert wird, wobei der Clip (6) die Form eines gebogenen Blechs aufweist, das ein sich von der Basis des Trägers (3) in einer Richtung zur Mitte des Sensorelements (1) erstreckendes horizontales Biegungsstück (6a), ein sich vom horizontalen Biegungsstück (6a) nach unten erstreckendes vertikales Biegungsstück (6b) und ein sich vom vertikalen Biegungsstück (6b) in einer Richtung zur Außenseite des Sensors (1) erstreckendes Abschlussbiegungsstück (6c) aufweist; und
ein Abstand (L) zwischen den Außenkanten (8a) der Schlitzöffnungen (8, 8') der Leiterplatte (7) kleiner ist als der Abstand zwischen den nächstgelegenen Teilen der beiden Träger (3) des Sensorelements (1) in der Ebene der Befestigung der Träger (3) an der Leiterplatte (7), wenn das Sensorelement nicht angebracht ist, so dass ein Druck der Träger (3) auf die Außenkanten (8a) der Schlitzöffnungen (8, 8') konstant aufrechterhalten wird, wenn das Sensorelement angebracht ist.

2. Kapazitative Sensoranordnung gemäß Anspruch 1, **dadurch gekennzeichnet, dass** die Träger (3) des Sensorelements (1) zwei Arme (4) enthalten, die jeweils ein oberes Ende (4a) und ein unteres Ende (4b) aufweisen, während jeder Arm (4) mit dem oberen Ende (4a) an der Seite der Plattform (2) angelenkt und in Richtung nach außen und entlang der Plattform (2) nach unten gebogen ist, während am unteren Ende (4b) beide Arme (4) über einen Abschlussteil (5) miteinander verbunden sind.

3. Kapazitative Sensoranordnung gemäß Anspruch 1, **dadurch gekennzeichnet, dass** die Träger (3) des Sensorelements (1) einen Arm (4) umfassen, der ein oberes Ende (4a) und ein unteres Ende (4b) aufweist, während der Arm (4) mit dem oberen Ende (4a) an der Plattform (2) in deren Mittelbereich angelenkt ist und in Richtung nach außen und entlang der Plattform (2) nach unten gebogen ist, während er an seinem unteren Ende von einem Abschlussteil (5) abgeschlossen ist.

4. Kapazitative Sensoranordnung gemäß Anspruch 2 oder 3, **dadurch gekennzeichnet, dass** der Abschlussteil (5) eines oder beider der beiden Träger (3) des Sensorelements (1) an der Basis durch den Clip (6) abgeschlossen ist.

5. Kapazitative Sensoranordnung gemäß Anspruch 2 oder 3, **dadurch gekennzeichnet, dass** der Abschlussteil (5) eines der beiden Träger (3) des Sensorelements (1) wenigstens einen an der Unterkante befindlichen Pin (10) zur Platzierung in die Schlitzöffnung (8) der Leiterplatte (7) aufweist.

6. Kapazitative Sensoranordnung gemäß einem der vorhergehenden Ansprüche, **dadurch gekennzeichnet, dass** die Plattform (2) und die Träger (3) des Sensorelements (1) durch Schneiden und Biegen aus einem Metallband einstückig ausgebildet sind.

7. Kapazitative Sensoranordnung gemäß einem der vorhergehenden Ansprüche, **dadurch gekennzeichnet, dass** die Plattform (2) des Sensorelements (1) eine Form aufweist, die ausgewählt ist aus rechteckig, oval, kreisförmig.

## Revendications

1. Agencement de capteur capacitif, comprenant une carte de circuit imprimé (7) et un élément capteur (1) monté sur la carte de circuit imprimé (7), dans lequel
l'élément capteur (1) contient une plate-forme (2) destinée à détecter la présence d'un élément à travers une feuille isolante (9), laquelle plate-forme (2) est articulée sur deux supports élastiquement déformables (3), adaptés pour se fixer à la carte de circuit imprimé (7) et maintenir la plate-forme (2) au-dessus de la carte de circuit imprimé (7), les supports (3) étant reliés à la plate-forme (2) par une articulation avec un axe de rotation (X-X) sur chaque côté duquel est située une partie de la plate-forme supérieure (2a, 2b) pour assurer le positionnement de la plate-forme (2) sur les supports (3) dans tout plan incliné donné par rapport à la surface de la carte de circuit imprimé (7) ou une flexion de la plate-forme (2),
**caractérisé en ce que**
la carte de circuit imprimé (7) contient au moins deux ouvertures en forme de fentes parallèles (8, 8') ayant des bords externes (8a) ;
au moins un des deux supports (3) de l'élément capteur (1) est terminé en bas par une attache (6) qui est placée dans une des au moins deux ouvertures en forme de fentes (8, 8') de la carte de circuit imprimé (7) pour fixer l'élément capteur (1) à la carte de circuit imprimé (7), l'attache (6) ayant la forme d'une feuille incurvée formant un pli horizontal (6a) s'étendant depuis le bas du support (3) dans une direction vers le milieu de l'élément capteur (1), un pli vertical (6b) s'étendant depuis le pli horizontal (6a) vers le bas, et un pli terminal (6c) s'étendant depuis le pli vertical (6b) dans une direction vers l'extérieur du capteur (1) ; et
une distance (L) entre les bords externes (8a) des ouvertures en forme de fentes (8, 8') de la carte de circuit imprimé (7) est inférieure à la distance entre les parties les plus proches des deux supports (3) de l'élément capteur (1) dans le plan de fixation des supports (3) à la carte de circuit imprimé (7) quand l'élément capteur n'est pas monté, de telle sorte qu'une pression des supports (3) sur les bords externes (8a) des ouvertures en forme de fentes (8, 8') est maintenue en permanence quand l'élément capteur est monté.

2. Agencement de capteur capacitif selon la revendication 1, **caractérisé en ce que** les supports (3) de l'élément capteur (1) contiennent deux bras (4), chacun ayant une extrémité supérieure (4a) et une extrémité inférieure (4b), tandis que chaque bras (4) est articulé par l'extrémité supérieure (4a) sur le côté de la plate-forme (2) et est plié vers le bas dans la direction vers l'extérieur et le long de la plate-forme (2), tandis qu'à l'extrémité inférieure (4b) les deux bras (4) sont reliés ensemble au moyen d'une partie terminale (5).

3. Agencement de capteur capacitif selon la revendication 1, **caractérisé en ce que** les supports (3) de l'élément capteur (1) contiennent un bras (4) ayant une extrémité supérieure (4a) et une extrémité inférieure (4b), tandis que le bras (4) est articulé par l'extrémité supérieure (4a) sur la plate-forme (2) dans sa région centrale et est incurvé vers le bas dans la direction vers l'extérieur et le long de la plate-forme (2), tandis qu'à l'extrémité inférieure il est terminé par une partie terminale (5).

4. Agencement de capteur capacitif selon la revendication 2 ou 3, **caractérisé en ce que** la partie terminale (5) d'un des deux supports (3) de l'élément capteur (1) ou des deux est terminé en bas par l'attache (6).

5. Agencement de capteur capacitif selon la revendication 2 ou 3, **caractérisé en ce que** la partie terminale (5) d'un des deux supports (3) de l'élément capteur (1) a au moins une broche (10) située sur le bord inférieur pour positionnement dans l'ouverture en forme de fente (8) de la carte de circuit imprimé (7).

6. Agencement de capteur capacitif selon l'une quelconque des revendications précédentes, **caractérisé en ce que** la plate-forme (2) et les supports (3) de l'élément capteur (1) sont fabriqués d'une seule pièce par découpe et pliage à partir d'une bande de métal.

7. Agencement de capteur capacitif selon l'une quelconque des revendications précédentes, **caractérisé en ce que** la plate-forme (2) de l'élément capteur (1) a une forme choisie parmi rectangulaire, ovale, circulaire.
